(19) Europäisches Patentamt
European Patent Office
Office européen des brevets

(11) **EP 3 424 215 B1**

(12) **EUROPÄISCHE PATENTSCHRIFT**

(45) Veröffentlichungstag und Bekanntmachung des Hinweises auf die Patenterteilung:
**19.10.2022 Patentblatt 2022/42**

(21) Anmeldenummer: **17700170.8**

(22) Anmeldetag: **09.01.2017**

(51) Internationale Patentklassifikation (IPC):
**H04N 9/31** *(2006.01)* **G02B 27/10** *(2006.01)*

(52) Gemeinsame Patentklassifikation (CPC):
**G02B 27/102; G02B 26/0833; G02B 27/104; G02B 27/141; G02B 27/30; H01S 5/4012; H01S 5/4025; H04N 9/3129; H04N 9/3155; H04N 9/3164; H04N 9/3185;** H01S 5/005; H01S 5/0071; H01S 5/02326; H01S 5/4093

(86) Internationale Anmeldenummer:
**PCT/EP2017/050322**

(87) Internationale Veröffentlichungsnummer:
**WO 2017/121698 (20.07.2017 Gazette 2017/29)**

(54) **VERFAHREN ZUM KALIBRIEREN EINER PROJEKTIONSVORRICHTUNG UND VERFAHREN ZUM BETREIBEN EINER SO KALIBRIERTEN PROJEKTIONSVORRICHTUNG**

METHOD FOR CALIBRATING A PROJECTION APPARATUS AND METHOD FOR OPERATING SUCH A CALIBRATED PROJECTION APPARATUS

PROCÉDÉ DE CALIBRATION D'UN APPAREIL DE PROJECTION ET PROCÉDÉ D'UTILISATION D'UN TEL APPAREIL DE PROJECTION CALIBRÉ

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **11.01.2016 EP 16150760**
**05.01.2017 DE 102017200101**

(43) Veröffentlichungstag der Anmeldung:
**09.01.2019 Patentblatt 2019/02**

(73) Patentinhaber: **Robert Bosch GmbH**
**70442 Stuttgart (DE)**

(72) Erfinder:
• **EHLERT, Alexander**
**72762 Reutlingen (DE)**

• **HEINZELMANN, Julian**
**70597 Stuttgart (DE)**

(56) Entgegenhaltungen:
**WO-A1-2009/025976 US-A1- 2015 208 048**
**US-B2- 8 884 975**

• **GLASBEY C A ET AL: "A review of image-warping methods", JOURNAL OF APPLIED STATISTICS, CARFAX PUBLISHING CO., ABINGDON, GB, Bd. 25, Nr. 2, 1. April 1998 (1998-04-01), Seiten 155-171, XP002570074, ISSN: 0266-4763, DOI: 10.1080/02664769823151**

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

## Beschreibung

## Stand der Technik

Die Erfindung bezieht sich auf sogenannte scannende Projektionsvorrichtungen zur Darstellung von diskret abgespeicherten Bildinformationen, deren Abtaststrahl sich aus mehreren Strahlkomponenten unterschiedlicher Lichtquellen zusammensetzt, wie z.B. Flying Spot Laser-Raster-Scanner. Die Erfindung dient der Kompensation des Versatzes zwischen den einzelnen Strahlkomponenten des Abtaststrahls einer derartigen Projektionsvorrichtung.

Die Bilderzeugung erfolgt hier mit Hilfe eines gepulsten Lichtstrahls, der die Projektionsfläche mit einer bestimmten Trajektorie überstreicht, z.B. zeilenweise. Dabei wird die Intensität dieses Abtaststrahls entsprechend der darzustellenden Bildinformation variiert. Wie bereits erwähnt, setzt sich der Abtaststrahl bei den hier in Rede stehenden Projektionsvorrichtungen aus mehreren Komponenten unterschiedlicher Lichtquellen zusammen, die unterschiedliche Wellenlängenbereiche abdecken. Idealerweise überlagern sich die Strahlkomponenten in der Projektionsebene und bilden ein einziges Pixel. Durch Variation der Intensität der einzelnen Lichtquellen kann so ein sehr großes Farbspektrum wiedergegeben werden.

Jedoch ist eine optimale Ausrichtung der Lichtquellen zum optischen Aufbau der Projektionsvorrichtung in der Praxis kaum zu erzielen, so dass in der Regel ein Versatz zwischen den Pixeln der einzelnen Strahlkomponenten besteht.

Die Bildinformation wird in Form von diskreten Abtastwerten zur Verfügung gestellt. Jeder Abtastwert ist einem Bildpunkt zugeordnet. Diese "idealen" Bildpunkte sind in einem Raster angeordnet, das die gesamte Bildfläche abdeckt und durch ganzzahlige Bildkoordinaten eines geradlinigen und in aller Regel orthogonalen Bildkoordinatensystems beschrieben wird.

Aufgrund des optischen Aufbaus, der für die Ausrichtung und Ablenkung der einzelnen Strahlkomponenten während des Scan-/Projektionsvorgangs erforderlich ist, weicht die tatsächliche Trajektorie des Abtaststrahls bzw. der einzelnen Strahlkomponenten des Abtaststrahls von diesem Raster ab, so dass die Lage der projizierten Pixel nicht den Rasterpunkten entspricht. Die projizierten Pixel spannen das sogenannte Projektor-Koordinatensystem auf, das im Unterschied zum Bildkoordinatensystem nicht geradlinig und orthogonal ist, sondern in aller Regel gekrümmt. In diesem Projektor-Koordinatensystem werden den projizierten Pixel ganzzahlige Projektor-Koordinaten zugeordnet.

Bei einem nicht korrigierten Pixel-Videostrom würde die Bildinformation eines bestimmten Bildpunkts dem Pixel zugeordnet, dessen Projektor-Koordinaten identisch mit den Bildkoordinaten dieses Bildpunkts sind. Dabei würden nahezu alle Pixel abweichend von den entsprechenden Bildkoordinaten projiziert. Im Ergebnis führt diese Vorgehensweise zu einer Bildverzerrung.

Um dies zu vermeiden, wird die nicht-lineare Abweichung der Projektor-Koordinaten von den Bildkoordinaten durch eine Vorverarbeitung der Bildinformation während des Projektionsprozesses kompensiert. Diese Vorverarbeitung der Bildinformation erfordert eine Kalibrierung der Projektionsvorrichtung. Dabei wird eine Funktion bestimmt, die die Projektor-Koordinaten der Pixel in Bildkoordinaten überführt, was als Dewarping bezeichnet wird.

Während des Projektionsvorgangs werden die Projektor-Koordinaten der einzelnen projizierten Pixel mit Hilfe dieser vorbestimmten Dewarping-Funktion in Bildkoordinaten umgerechnet, um dem jeweiligen Pixel dann die Bildinformation zuzuordnen, die seiner Position in der Bildfläche entspricht. Die Bildkoordinaten der realen Pixel sind in der Regel nicht ganzzahlig. Deshalb wird der Regelung der Intensität der entsprechenden Lichtquelle meist nicht nur ein einziger Abtastwert der Bildinformation zugrunde gelegt, sondern ein Mittelwert von Abtastwerten in einer zu definierenden Umgebung der Bildkoordinaten des realen Pixels. Durch diese Vorverarbeitung der Bildinformation wird die nicht-lineare Abweichung zwischen Bildkoordinaten und Projektor-Koordinaten kompensiert und eine entsprechende Bildverzerrung vermieden.

Die Komplexität und damit der Rechenaufwand für das Dewarping hängt zum einen von der Art des optischen Aufbaus ab, der für die Ausrichtung und Ablenkung der einzelnen Strahlkomponenten während des Scan-/Projektionsvorgangs gewählt und realisiert wurde, und zum anderen von der angestrebten Güte der Bildwiedergabe. Wenn das Dewarping auf alle Lichtquellen angewendet wird, die am Projektionsprozess beteiligt sind, wird nicht nur die Bildverzerrung kompensiert, sondern auch der dieser Bildverzerrung überlagerte Versatz zwischen den Farbanteilen der einzelnen Pixel. Je nach Anzahl der beteiligten Lichtquellen ist dies mit einem sehr hohen Rechenaufwand verbunden.

In der WO 2009/025976 wird eine Möglichkeit vorgeschlagen, den Versatz zwischen den einzelnen Strahlkomponenten in der Projektionsebene weitgehend unabhängig von der Bildverzerrung zu kompensieren. Dazu wird zunächst in einem initialen Kalibrierschritt für jede Strahl-/Farbkomponente ein dem Versatz entsprechender Offset bestimmt. Gemäß der WO 2009/025976 wird die Bildinformation während des Projektionsprozesses in einen Zwischenspeicher geschrieben, in dem die Bildinformation eines gesamten Bildes abgelegt wird, und zwar aufgeteilt nach Farbkanälen und versehen mit Positionsinformationen. Dabei wird die Bildinformation jedes Farbkanals bzw. die zugehörigen Positionsinformationen mit dem jeweiligen vorab bestimmten Offset beaufschlagt. Die so gewonnenen Bildinformationen werden dann als Eingangsdaten für ein Dewarping-Verfahren und eine darauf basierende Kompensation der Bildverzerrung genutzt. Im Fall der WO 2009/025976 wird das Dewarping also nur für eine einzige am Projektionsprozess beteiligte Lichtquelle vorgenommen, was den Rechenaufwand deutlich begrenzt.

Die in der WO 2009/025976 beschriebene Variante der Kompensation des Versatzes zwischen den einzelnen Strahlkomponenten des Abtaststrahls einer Projektionsvorrichtung erfordert allerdings einen relativ großen Zwischenspeicher für die Bildinformation. Dies erweist sich für einige Anwendungen, wie z.B. mobile Projektionsvorrichtungen aus dem Bereich der Consumer Elektronik, als problematisch.

Die Druckschrift Glasbey C. et al.: "A review of image-warping methods", Journal of apllied statistics, Carfax publishing Co., Bd. 25, Nr. 2, 1. April 1998, S. 155 - 171, beschreibt parametrische und nicht-parametrische Ansätze betreffend Verzerrungen in Bildern.

## Aufgabe der Erfindung

Mit der Erfindung wird eine Möglichkeit zur Verfügung gestellt, den Versatz zwischen den einzelnen Strahlkomponenten des Abtaststrahls einer Projektionsvorrichtung ohne erhöhten Speicherbedarf für die Bildinformation und mit einem vergleichsweise geringen Rechenaufwand zu kompensieren.

## Kern und Vorteile der Erfindung

Erfindungsgemäß ist erkannt worden, dass sich nicht nur die Bildverzerrung für alle Strahlkomponenten einzeln bestimmen lässt, sondern auch der Versatz jeder einzelnen Strahlkomponente zu einem vorab bestimmten Referenzstrahl. Dabei sind sowohl der Versatz als auch die Verzerrung ortsabhängig. So sind die Verzerrung und der Versatz in der Regel an den Bildrändern größer als in der Bildmitte. Die Erfindung beruht auf der Annahme, dass sich der Versatz zwischen den Pixeln der einzelnen Strahlkomponenten mit einem geringeren Rechenaufwand beschreiben lässt, als die Überführung der Projektor-Koordinaten in die Bildkoordinaten der Pixel.

Erfindungsgemäß wird deshalb vorgeschlagen, eine Kalibrierung der Projektionsvorrichtung gemäß dem unabhängigen Anspruch 1 vorzunehmen. Die abhängigen Ansprüche definieren vorteilhafte Ausführungsformen.

Beim Betreiben der Projektionsvorrichtung werden die so gewonnenen Dewarping-Funktionen für den Referenzstrahl und die Versatzfunktionen für die einzelnen Strahlkomponenten dann zur Bestimmung der Bildkoordinaten der Pixel der einzelnen Lichtquellen genutzt. Dazu schlägt die Erfindung vor, das Betreiben einer Projektionsvorrichtung gemäß Anspruch 7 vorzunehmen.

Die so gewonnenen Bildkoordinaten werden dann einer Vorverarbeitung der Bildinformation zugrunde gelegt, die durch entsprechende Ansteuerung der einzelnen Lichtquellen eine Kompensation der Bildverzerrung und des Versatzes ermöglicht.

Mit dem erfindungsgemäßen Kalibrierverfahren in Verbindung mit dem erfindungsgemäßen Verfahren zum Betreiben einer Projektionsvorrichtung wird also eine vergleichsweise einfache Möglichkeit zu Verfügung gestellt, mit der die Projektor-Koordinaten der von den einzelnen Lichtquellen erzeugten Pixel während des Projektionsprozesses in Bildkoordinaten überführt werden können. Die eigentliche Kompensation sowohl der Bildverzerrung als auch des Versatzes zwischen den Pixeln der unterschiedlichen Lichtquellen erfolgt dann erst im Rahmen einer Prozessierung der abgespeicherten Bildinformation. Diese Prozessierung basiert auf den erfindungsgemäß ermittelten Bildkoordinaten der Pixel.

Erfindungsgemäß wird im Rahmen des Kalibrierverfahrens ein Referenzstrahl für den Abtaststrahl bestimmt. Vorteilhafterweise wird hier einfach eine beliebige Strahlkomponente des Abtaststrahls als Referenzstrahl gewählt. In diesem Fall ist dann jeweils der Versatz der übrigen Strahlkomponenten zu diesem Referenzstrahl zu bestimmen. Es besteht aber auch die Möglichkeit, einen Referenzstrahl als Mittelung über die Strahlkomponenten zu definieren. In diesem Fall muss der Versatz zum Referenzstrahl für alle Strahlkomponenten bestimmt werden.

Erfindungsgemäß werden im Rahmen des Kalibrierverfahrens zumindest für den Referenzstrahl einmalig eine x- und eine y-Dewarping-Funktion ermittelt, die die Projektor-Koordinaten der jeweiligen Pixel möglichst genau in Bildkoordinaten umwandelt. In einer möglichen Variante des Kalibrierverfahrens werden außerdem auch für alle übrigen Strahlkomponenten einmalig eine x- und y-Dewarping-Funktion ermittelt. Um die x- und y-Versatzfunktionen dann jeweils durch die Differenz zwischen den Dewarping-Funktionen der jeweiligen Strahlkomponente und den Dewarping-Funktionen des Referenzstrahls zu bestimmen.

In jedem Fall erweist es sich als vorteilhaft, die Dewarping-Funktionen für den Referenzstrahl und ggf. auch für die übrigen Strahlkomponenten durch Polynome n-ten Grades anzunähern. Vorteilhafterweise werden auch die Versatzfunktionen durch Polynome m-ten Grades angenähert. Da davon auszugehen ist, dass sich der Versatz zwischen den Pixeln der einzelnen Strahlkomponenten in Grenzen hält, können die Versatzfunktionen zumeist durch Polynome geringerer Ordnung als die Dewarping-Polynome angenähert werden, d.h. m<n.

Dies reduziert den Rechenaufwand für die Bestimmung der Bildkoordinaten der einzelnen Pixel während des Projektionsvorgangs wesentlich. Der Rechenaufwand für die Berechnung von Polynomen nimmt nämlich mit dem Grad des Polynoms deutlich ab. Erfindungsgemäß müssen die Dewarping-Polynome höherer Ordnung nur einmal, nämlich für den Referenzstrahl berechnet werden, um die entsprechenden Bildkoordinaten zu bestimmen. Für die Bildkoordinaten der Pixel der übrigen Strahlkomponenten werden lediglich die Versatz-Polynome geringerer Ordnung berechnet, um dann dieses Ergebnis auf das bereits vorliegende Ergebnis für den Referenzstrahl aufzuaddieren.

**Zeichnungen**

Vorteilhafte Ausführungsformen und Weiterbildungen der Erfindung werden nachfolgend anhand der Figuren näher erläutert. Im Einzelnen zeigen:

**Fig.1**    einen Ausschnitt der Bild- bzw. Projektionsfläche 10 mit einer Überlagerung des Projektor-Koordinatensystems und des Bildkoordinatensystems einer Projektionsvorrichtung, die erfindungsgemäß kalibriert und betrieben werden kann,

**Fig. 2**    die Positionen der Pixel zweier Lichtquellen auf der Projektionsfläche, bzw. den Versatz zwischen diesen Pixelpositionen, und

**Fig. 3**    ein Blockdiagramm zur Veranschaulichung des erfindungsgemäßen Verfahrens zum Betreiben einer Projektionsvorrichtung.

**Beschreibung von Ausführungsbeispielen**

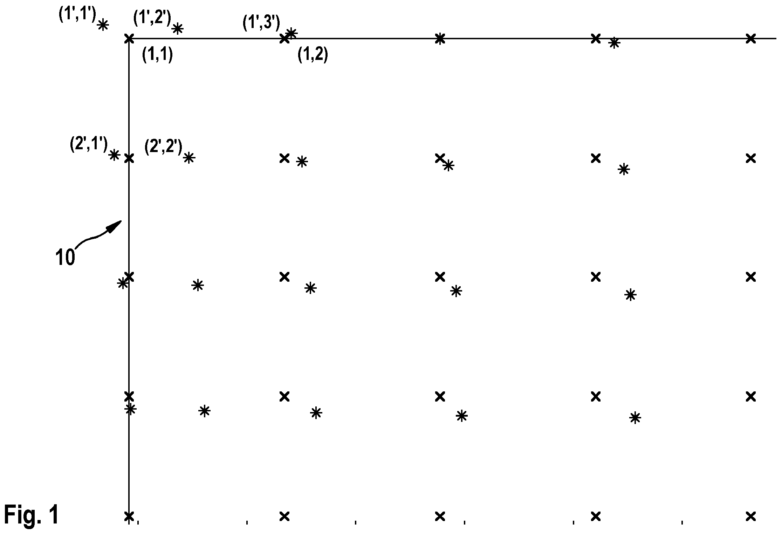

**Fig. 1** zeigt die Bild- bzw. Projektionsfläche 10 einer Projektionsvorrichtung der hier in Rede stehenden Art, wie beispielsweise eines sogenannten Flying-Spot Laser Raster-Scanners. Fig. 1 veranschaulicht die Abweichung der Lage der tatsächlich erzeugten Pixel des Abtaststrahls, hier dargestellt als Sterne, von den Positionen in der Bildfläche 10, denen die diskret abgespeicherte Bildinformation zugeordnet ist. Diese Positionen sind hier als Kreuze dargestellt. Die Kreuze sind in einem Raster, äquidistant innerhalb einer Zeile bzw. einer Spalte, angeordnet. Dieses Raster bildet ein geradliniges und orthogonales Bildkoordinatensystem und deckt die gesamte Bildfläche 10 ab. Die einzelnen Rasterpunkte, d.h. die Positionen, die der diskret abgespeicherten Bildinformation zugeordnet sind, werden durch ganzzahlige Bildkoordinaten beschrieben.

Der optische Pfad, d.h. die Trajektorie des Abtaststrahls, weicht von diesem Raster ab, so dass die Lage der projizierten Pixel nicht den Rasterpunkten entspricht. Die projizierten Pixel spannen das Projektor-Koordinatensystem auf, das im Unterschied zum Bildkoordinatensystem nicht geradlinig und orthogonal ist, sondern in aller Regel gekrümmt, und zwar in Abhängigkeit vom optischen Aufbau der Projektionsvorrichtung. In diesem Projektor-Koordinatensystem haben die projizierten Pixel ganzzahlige Projektor-Koordinaten. Im vorliegenden Fall decken die Projektor-Koordinaten eine größere Fläche ab, als die Bildfläche. Das Projektor-Koordinatensystem ist also gegenüber dem Bildkoordinatensystem verzerrt. Fig. 1 veranschaulicht, dass diese Verzerrung an den Bildrändern stärker ausgeprägt ist als in der Bildmitte.

Bei einem nicht korrigierten Pixel-Videostrom würde die Bildinformation eines bestimmten Bildpunkts dem Pixel zugeordnet, dessen Projektor-Koordinaten identisch mit den Bildkoordinaten dieses Bildpunkts sind. Konkret heißt das beispielsweise, dass dem Pixel (1',1') die Bildinformation des Bildpunkts (1,1) zugeordnet würde, obwohl dieser Pixel außerhalb der Bildfläche liegt. So wie der Pixel (1', 1') würden auch nahezu alle anderen Pixel abweichend von den entsprechenden Bildkoordinaten projiziert. Im Ergebnis führt diese Vorgehensweise zu einer Bildverzerrung. Dabei kann es sich um eine Verdrehung, Kissenverzerrung, Trapezverzerrung oder anderweitige Abweichung höherer Ordnung handeln.

Um eine entsprechende Bildverzerrung zu vermeiden, wird die nicht-lineare Abweichung der Projektor-Koordinaten von den Bildkoordinaten durch eine Vorverarbeitung der Bildinformation während des Projektionsprozesses kompensiert. Dafür müssen die Projektor-Koordinaten der Pixel aber zunächst in Bildkoordinaten überführt werden, was als Dewarping bezeichnet wird. Die so gewonnenen Bildkoordinaten der Pixel sind in der Regel nicht ganzzahlig. Um jedem Pixel möglichst die Bildinformation zuzuordnen, die seiner Position in der Bildfläche entspricht, wird jedem Pixel in der Regel nicht nur ein einziger Abtastwert der Bildinformation zugeordnet, sondern ein Mittelwert von Abtastwerten in einer zu definierenden Umgebung der ermittelten Bildkoordinaten des Pixels. Durch diese Vorverarbeitung der Bildinformation wird die nicht-lineare Abweichung zwischen Bildkoordinaten und Projektor-Koordinaten kompensiert und eine entsprechende Bildverzerrung vermieden.

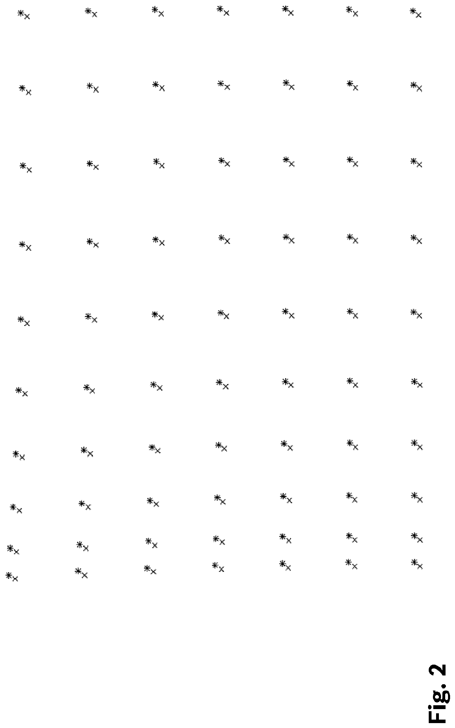

Dem voranstehend in Verbindung mit Fig. 1 beschriebenen Effekt ist ein weiterer Effekt überlagert, wenn die Projektionsvorrichtung mehrere Lichtquellen umfasst. In diesem Fall setzt sich der Abtaststrahl aus mehreren Strahlkomponenten zusammen, die eine farbige Bildwiedergabe ermöglichen. Dabei kann es sich beispielsweise um Laserdioden der Farben rot, grün und blau handeln. Es können aber auch zwei rote Laserdioden, eine grüne und eine blaue Laserdiode vorgesehen sein. In der Praxis beschreiben die einzelnen Strahlkomponenten aufgrund des optischen Aufbaus eine im Wesentlichen gleiche Trajektorie. Idealerweise überlagern sich die Pixel der einzelnen Lichtquellen bzw. Strahlkomponenten. In der Praxis tritt jedoch häufig ein Versatz zwischen den Pixeln der einzelnen Lichtquellen auf, der auf unvermeidbare Justagefehler des optischen Aufbaus zurückzuführen ist. Diesen Versatz zwischen den beiden Strahlkomponenten des Abtaststrahls einer Projektionsvorrichtung der hier in Rede stehenden Art veranschaulicht **Fig. 2**. Dargestellt ist die Projektionsebene bzw. Bildfläche mit dem Raster der Pixelpositionen der beiden Strahlkomponenten, die hier jeweils durch Kreuze und Sterne dargestellt sind. Fig. 2 verdeutlicht, dass dieser Versatz zwar ebenfalls abhängig von der Position der Pixel auf der Bildfläche ist aber im Wesentlichen translatorisch ist.

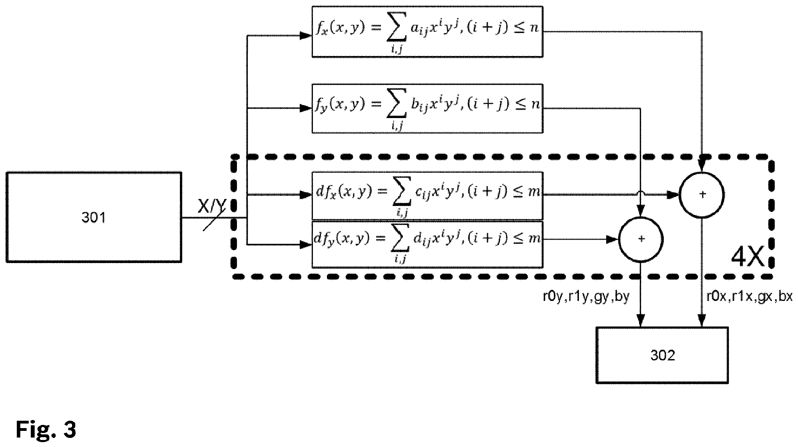

Deshalb werden erfindungsgemäß während des Projektionsprozesses nicht für alle Strahlkomponenten die Bildkoordinaten der Pixel mit Hilfe einer Dewarping-Funktion ermittelt, sondern nur für einen vorab zu bestimmenden Referenzstrahl. Für die Pixel der übrigen Strahlkomponenten wird dann lediglich der Versatz zu den entsprechenden Pixeln des Referenzstrahls ermittelt und auf die Bildkoordinaten dieses Referenzpixels aufaddiert, was durch das Blockdiagramm der **Fig. 3** veranschaulicht wird.

Fig. 3 bezieht sich auf eine Projektionsvorrichtung mit insgesamt vier Lichtquellen, nämlich zwei roten Laserdioden r0 und r1, einer grünen Laserdiode g und einer blauen Laserdiode b. Diesen ist ein Rasterisierer 301 zugeordnet, der den Pixeln der einzelnen Lichtquellen bzw. Strahlkomponenten Projektor-Koordinaten x, y zuweist, wobei zeitgleich erzeugten Pixeln der unterschiedlichen Lichtquellen r0, r1, g und b identische Projektor-Koordinaten x, y zugewiesen werden. Diese Projektor-Koordinaten x, y werden mit Hilfe einer x-Dewarping-Funktion und einer y-Dewarping-Funktion in Bildkoordinaten überführt. Im hier beschriebenen Ausführungsbeispiel handelt es sich bei diesen beiden Dewarping-Funktionen jeweils um ein Polynom 5ter Ordnung vom Typ $f(x,y) = \sum_{i,j} a_{ij} x^i y^j$, $(i + j) \leq 5$, die vorab im Rahmen eines Kalibrierverfahrens für eine Referenzlichtquelle bzw. für einen Referenzstrahl ermittelt worden sind. Die Projektor-Koordinaten x, y dienen außerdem zur Ermittlung des Versatzes der Pixel aller übrigen Lichtquellen bzw. Strahlkomponenten zum Referenzstrahl. Dies erfolgt mit Hilfe einer x-Versatzfunktion und einer y-Versatzfunktion, die vorab im Rahmen des Kalibrierverfahrens individuell für jede Lichtquelle ermittelt worden sind. Im hier beschriebenen Ausführungsbeispiel handelt es sich bei diesen Versatzfunktionen jeweils um ein Polynom 3ter Ordnung vom Typ $df(x, y) = \sum_{i,j} a_{ij} x^i y^j$, $(i + j) \leq 3$. Die Bildkoordinaten r0y, r1y, gy, by und r0x, r1x, gx, bx für die Pixel der einzelnen Strahlkomponenten werden schließlich bestimmt, indem zunächst für jede Strahlkomponente der individuelle Versatz zum Referenzstrahl ermittelt wird. Dieser wird dann auf die Bildkoordinaten des Referenzstrahls aufaddiert, die mit Hilfe der Dewarping-Funktionen für den Referenzstrahl ermittelt worden sind.

Wie bereits voranstehend beschrieben, werden die so gewonnenen Bildkoordinaten dann einer Vorverarbeitung der Bildinformation zugrunde gelegt. Dabei werden Intensitätswerte für die einzelnen Strahlkomponenten bestimmt, die der jeweiligen Position der Pixel in der Bildfläche entsprechen. Die Bildinformation ist in einer Speicherkomponente 302 abgelegt.

Wie bereits erwähnt, wird im Rahmen des erfindungsgemäßen Kalibrierverfahrens ein Referenzstrahl für den Abtaststrahl bestimmt. Dabei kann es sich einfach um eine beliebige Strahlkomponente des Abtaststrahls handeln. Der Referenzstrahl kann aber auch als Mittelung über die Strahlkomponenten definiert werden. Das in Fig. 3 dargestellte Blockdiagramm umfasst beide Varianten, weil hier für alle Strahlkomponenten der Versatz zum Referenzstrahl bestimmt wird. Fungiert eine Strahlkomponente als Referenzstrahl, dann wird der Versatz für diese Strahlkomponente einfach auf Null gesetzt.

Im Rahmen des Kalibrierverfahrens wird zumindest für einen Referenzstrahl die Abweichung der Projektor-Koordinaten der jeweiligen Pixel zu den Bildkoordinaten ermittelt. Dazu kann beispielsweise ein Kamerasystem verwendet werden. Auf Basis der so gewonnenen Informationen wird eine Funktion als Dewarping-Funktion bestimmt, die diese Abweichung möglichst gut annähert. Dafür bieten sich Polynome höherer Ordnung an, wie im hier beschriebenen Ausführungsbeispiel. Die Versatzfunktionen für die einzelnen Strahlkomponenten werden vorteilhafterweise ebenfalls durch Polynome angenähert. Da davon auszugehen ist, dass sich der Versatz zwischen den Pixeln der einzelnen Strahlkomponenten in Grenzen hält, können die Versatzfunktionen vorteilhafterweise durch Polynome geringerer Ordnung als die Dewarping-Polynome angenähert werden.

**Patentansprüche**

1. Verfahren zum Kalibrieren einer Projektionsvorrichtung zur Darstellung von diskret abgespeicherten Bildinformationen mit Hilfe von

   • mindestens zwei ansteuerbaren und regelbaren Lichtquellen (r0, r1, g, b), die jeweils eine Strahlkomponente eines Abtaststrahls aussenden, und die jeweils ein entsprechendes Pixel auf einer Projektionsfläche (10) generieren und
   • mit Mitteln zum Fokussieren, Ausrichten und Bewegen der Strahlkomponenten, so dass sich die entsprechenden Pixel auf der Projektionsfläche (10) möglichst überlagern und in einer vorgegebenen Trajektorie über die Projektionsfläche (10) bewegen lassen,

   wobei jedem von einer Lichtquelle (r0, r1, g, b) generierten Pixel eine x- und eine y-Projektor-Koordinate entsprechend seiner Position auf der Trajektorie zugeordnet werden, wobei zeitgleich generierten Pixeln unterschiedlicher Lichtquellen dieselben x- und y- Projektor-Koordinaten zugeordnet werden wobei das Verfahren die folgenden Schritte umfasst:

   a. Bestimmung eines Referenzstrahls für den Abtaststrahl;
   b. Bestimmung jeweils einer ortsabhängigen Dewarping-Funktion ($f_x$, $f_y$) für die x-Projektor-Koordinate und für die y-Projektor-Koordinate des Referenzstrahls,
   wobei jede ortsabhängige Dewarping-Funktion ($f_x$, $f_y$) die jeweilige Projektor-Koordinate in entsprechende Bildkoordinaten überführt, die der Bildinformation zugeordnet sind;
   c. Bestimmung jeweils einer ortsabhängigen Versatzfunktion ($df_x$, $df_y$) für die x-Projektor-Koordinate und die y-Projektor-Koordinate für alle Strahlkomponenten,

wobei jede ortsabhängige Versatzfunktion ($df_x$, $df_y$) einen Versatz zwischen der jeweiligen x- oder y-Bildkoordinate des Referenzstrahls und der x- oder y-Bildkoordinate der jeweiligen Strahlkomponente annähert;

d. Bereitstellen der ortsabhängigen Dewarping-Funktionen für den

Referenzstrahl, wobei die ortsabhängigen Dewarping-Funktionen ($f_x$, $f_y$) durch Polynomfunktionen vom Grad n angenähert werden und

e. Bereitstellen der ortsabhängigen Versatzfunktionen ($df_x$, $df_y$) für alle Strahlkomponenten, wobei die ortsabhängigen Versatzfunktionen für die einzelnen Strahlkomponenten durch Polynomfunktionen vom Grad m angenähert werden und wobei m<n.

**2.** Kalibrierverfahren nach Anspruch 1, wobei für alle Strahlkomponenten des Abtaststrahls jeweils eine ortsabhängige Dewarping-Funktion ($f_x$, $f_y$) für die x-Projektor-Koordinate und für die y-Projektor-Koordinate bestimmt werden, wobei jede Dewarping-Funktion ($f_x$, $f_y$) die jeweilige Projektor-Koordinate in entsprechende Bildkoordinaten überführt, die der Bildinformation zugeordnet sind, und

wobei die jeweiligen ortsabhängigen Versatzfunktionen ($df_x$, $df_y$) für die x-Projektor-Koordinate und die y-Projektor-Koordinate für alle Strahlkomponenten bestimmt werden, indem ein Versatz zwischen der jeweiligen x- oder y-Dewarping-Funktion des Referenzstrahls und der x- oder y-Dewarping-Funktion der jeweiligen Strahlkomponente angenähert wird.

**3.** Kalibrierverfahren nach einem der Ansprüche 1 oder 2, wobei eine Strahlkomponente des Abtaststrahls als Referenzstrahl bestimmt wird.

**4.** Kalibrierverfahren nach einem der Ansprüche 1 oder 2, wobei der Referenzstrahl bestimmt wird, indem über Strahlengänge der einzelnen Strahlkomponenten gemittelt wird.

**5.** Kalibrierverfahren nach einem der Ansprüche 1 bis 4, wobei die ortsabhängigen Dewarping-Funktionen ($f_x$, $f_y$) durch

$$f(x,y) = \sum_{i,j} a_{ij} x^i y^j, (i+j) \leq n$$

angenähert werden.

**6.** Kalibrierverfahren nach einem der Ansprüche 1 bis 4, wobei die ortsabhängigen Versatzfunktionen ($df_x$, $df_y$) durch

$$df(x,y) = \sum_{i,j} a_{ij} x^i y^j, (i+j) \leq m$$

angenähert werden.

**7.** Verfahren zum Betreiben der Projektionsvorrichtung,

wobei die Projektionsvorrichtung gemäß einem der Ansprüche 1 bis 4 kalibriert worden ist, wobei jede der x- und y-Projektor-Koordinaten mit Hilfe der jeweiligen ortsabhängigen Dewarping-Funktion ($f_x$, $f_y$) in entsprechende Bildkoordinaten der Bildinformation überführt werden, wobei die so bestimmten Bildkoordinaten als Referenz-Pixelposition für alle Lichtquellen fungieren, wobei der Versatz der Position der von den einzelnen Lichtquellen (r0, r1, g, b) generierten Pixel zu der entsprechenden Referenz-Pixelposition mit Hilfe der jeweiligen ortsabhängigen Versatzfunktion ($df_x$, $df_y$) bestimmt wird, und wobei dieser für jede Lichtquelle individuell bestimmte Versatz auf die Bildkoordinaten der Referenz-Pixelposition aufaddiert wird, um die Bildkoordinaten der Pixel der einzelnen Lichtquellen (r0, r1, g, b) individuell zu bestimmen.

## Claims

**1.** Method for calibrating a projection apparatus for presenting discretely stored image information with the aid of

• at least two controllable and regulable light sources (r0, r1, g, b), which each emit a beam component of a scanning beam and which each generate a corresponding pixel on a projection surface (10), and
• with means for focusing, aligning and moving the beam components so that the corresponding pixels overlay one another if possible on the projection surface (10) and can be moved over the projection surface (10) in a specified trajectory, wherein each pixel generated by a light source (r0, r1, g, b) is assigned an x projector coordinate and a y projector coordinate corresponding to its position on the trajectory, wherein simultaneously generated pixels of different light sources are assigned the same x and y projector coordinates,

wherein the method comprises the following steps:

a. determining a reference beam for the scanning beam;

b. determining in each case one spatially dependent dewarping function ($f_x$, $f_y$) for the x projector coordinate and for the y projector coordinate of the reference beam, wherein each spatially dependent dewarping function ($f_x$, $f_y$) transforms the respective projector coordinate to corresponding image coordinates that are assigned to the image information;

c. determining in each case one spatially dependent displacement function ($df_x$, $df_y$) for the x projector coordinate and the y projector coordinate for all beam components, wherein each spatially dependent displacement function ($df_x$, $df_y$) approximates a displacement between the respective x or y image coordinate of the reference beam and the x or y image coordinate of the respective beam component;

d. providing the spatially dependent dewarping functions for the reference beam, wherein the spatially dependent dewarping functions ($f_x$, $f_y$) are approximated by polynomial functions of degree n, and

e. providing the spatially dependent displacement functions ($df_x$, $df_y$) for all beam components, wherein the spatially dependent displacement functions for the individual beam components are approximated by polynomial functions of degree m, and wherein m<n.

2. Calibration method according to Claim 1, wherein for all beam components of the scanning beam in each case one spatially dependent dewarping function ($f_x$, $f_y$) for the x projector coordinate and for the y projector coordinate are determined,

wherein each dewarping function ($f_x$, $f_y$) transforms the respective projector coordinate to corresponding image coordinates that are assigned to the image information, and
wherein the respective spatially dependent displacement functions ($df_x$, $df_y$) for the x projector coordinate and the y projector coordinate are determined for all beam components by virtue of the fact that a displacement between the respective x or y dewarping function of the reference beam and the x or y dewarping function of the respective beam component is approximated.

3. Calibration method according to either of Claims 1 and 2, wherein one beam component of the scanning beam is determined as reference beam.

4. Calibration method according to either of Claims 1 and 2, wherein the reference beam is determined by virtue of the fact that averaging is performed over beam paths of the individual beam components.

5. Calibration method according to any of Claims 1 to 4, wherein the spatially dependent dewarping functions ($f_x$, $f_y$) are approximated by

$$f(x,y) = \sum_{i,j} a_{ij} x^i y^j, (i+j) \leq n.$$

6. Calibration method according to any of Claims 1 to 4, wherein the spatially dependent displacement functions ($df_x$, $df_y$) are approximated by

$$df(x,y) = \sum_{i,j} a_{ij} x^i y^j, (i+j) \leq m.$$

7. Method for operating the projection apparatus, wherein the projection apparatus has been calibrated according to any of Claims 1 to 4,

wherein each of the x and y projector coordinates is transformed to corresponding image coordinates of the image information by means of the respective spatially dependent dewarping function ($f_x$, $f_y$),
wherein the image coordinates thus determined function as reference pixel position for all light sources, wherein the displacement of the position of the pixels generated by the individual light sources (r0, r1, g, b) with respect to the corresponding reference pixel position is determined with the aid of the respective spatially dependent displacement function ($df_x$, $df_y$), and wherein this displacement individually determined for each light source is added to the image coordinates of the reference pixel position in order to individually determine the image coordinates of the pixels of the individual light sources (r0, r1, g, b).

**Revendications**

1. Procédé permettant d'étalonner un dispositif de projection pour la représentation d'informations d'image stockées séparément, à l'aide

• d'au moins deux sources de lumière (r0, r1, g, b) pouvant être pilotées et régulées et qui émettent respectivement une composante de faisceau d'un faisceau de balayage, et qui génèrent respectivement un pixel correspondant sur une surface de projection (10), et
• avec des moyens permettant de mettre au point, aligner et déplacer la composante de faisceau de sorte que les pixels correspondants sur la surface de projection (10) se superposent dans la mesure du possible et peuvent être déplacés selon une trajectoire prédéfinie à travers la surface de projection (10),

dans lequel on associe à chaque pixel généré par une source de lumière (r0, r1, g, b) une coordonnée de projecteur x et y selon sa position sur la trajectoire, dans lequel les mêmes coordonnées de projecteur x et y sont associées à des pixels de différentes sources de lumière, générés en même temps,

le procédé comprenant les étapes suivantes consistant à :

a. déterminer un faisceau de référence pour le faisceau de balayage ;

b. déterminer respectivement une fonction de dégauchissement dépendante de l'emplacement ($f_x$, $f_y$) pour la coordonnée de projecteur x et pour la coordonnée de projecteur y du faisceau de référence,

dans lequel chaque fonction de dégauchissement dépendante de l'emplacement ($f_x$, $f_y$) convertit la coordonnée de projecteur respective en coordonnées d'image correspondantes qui sont associées à l'information d'image ;

c. déterminer respectivement une fonction de décalage dépendante de l'emplacement ($df_x$, $df_y$) pour la coordonnée de projecteur x et la coordonnée de projecteur y pour toutes les composantes de faisceau,

dans lequel chaque fonction de décalage dépendante de l'emplacement ($df_x$, $df_y$) approxime un décalage entre la coordonnée d'image x ou y respective du faisceau de référence et la coordonnée d'image x ou y de la composante de faisceau respective ;

d. fournir les fonctions de dégauchissement dépendantes de l'emplacement pour le faisceau de référence, les fonctions de dégauchissement dépendantes de l'emplacement ($f_x$, $f_y$) étant approximées par des fonctions polynomiales de degré n, et

e. fournir les fonctions de décalage dépendantes de l'emplacement ($df_x$, $df_y$) pour toutes les composantes de faisceau, les fonctions de décalage dépendantes de l'emplacement étant approximées pour les composantes de faisceau individuelles par des fonctions polynomiales de degré m, et où m < n.

2. Procédé d'étalonnage selon la revendication 1, dans lequel, pour toutes les composantes de faisceau du faisceau de balayage, respectivement une fonction de dégauchissement dépendante de l'emplacement ($f_x$, $f_y$) est déterminée pour la coordonnée de projecteur x et pour la coordonnée de projecteur y, dans lequel chaque fonction de dégauchissement ($f_x$, $f_y$) convertit la coordonnée de projecteur respective en coordonnées d'image correspondantes qui sont associées à l'information d'image, et

dans lequel les fonctions de décalage dépendantes de l'emplacement ($df_x$, $df_y$) respectives pour la coordonnée de projecteur x et la coordonnée de projecteur y sont déterminées pour toutes les composantes de faisceau en ce qu'un décalage entre la fonction de dégauchissement x ou y respective du faisceau de référence et la fonction de dégauchissement x ou y de la composante de faisceau respective est approximé.

3. Procédé d'étalonnage selon l'une quelconque des revendications 1 ou 2, dans lequel une composante de faisceau du faisceau de balayage est déterminée comme le faisceau de référence.

4. Procédé d'étalonnage Kalibrierverfahren selon l'une quelconque des revendications 1 ou 2, dans lequel le faisceau de référence est déterminé en ce qu'une moyenne est établie sur les trajets de faisceau des composantes de faisceau individuelles.

5. Procédé d'étalonnage selon l'une quelconque des revendications 1 à 4, dans lequel les fonctions de dégauchissement dépendantes de l'emplacement ($f_x$, $f_y$) sont approximées par

$$f(x,y) = \sum_{i,j} a_{ij} x^i y^j, (i+j) \leq n$$

6. Procédé d'étalonnage selon l'une quelconque des revendications 1 à 4, dans lequel les fonctions de décalage dépendantes de l'emplacement ($df_x$, $df_y$) sont approximées par

$$df(x,y) = \sum_{i,j} a_{ij} x^i y^i, (i+j) \leq m$$

7. Procédé permettant de faire fonctionner le dispositif de projection, le dispositif de projection ayant été étalonné selon l'une quelconque des revendications 1 à 4,

dans lequel chacune des coordonnées de projecteur x et y est convertie à l'aide de la fonction de dégauchissement dépendante de l'emplacement ($f_x$, $f_y$) respective en coordonnées d'image correspondantes de l'information d'image,

dans lequel les coordonnées d'image ainsi déterminées servent de position de pixel de référence pour toutes les sources de lumière,

dans lequel le décalage de la position des pixels

**EP 3 424 215 B1**

générés par les sources de lumière (r0, r1, g, b) individuelles par rapport à la position de pixel de référence correspondante est déterminé à l'aide de la fonction de décalage dépendante de l'emplacement $(df_x, df_y)$ respective, et

dans lequel ce décalage déterminé individuellement pour chaque source de lumière est additionné aux coordonnées d'image de la position de pixel de référence pour déterminer individuellement les coordonnées d'image des pixels des sources de lumière (r0, r1, g, b) individuelles.

Fig. 1

Fig. 2

$$f_x(x,y) = \sum_{i,j} a_{ij} x^i y^j, (i+j) \leq n$$

$$f_y(x,y) = \sum_{i,j} b_{ij} x^i y^j, (i+j) \leq n$$

$$df_x(x,y) = \sum_{i,j} c_{ij} x^i y^j, (i+j) \leq m$$

$$df_y(x,y) = \sum_{i,j} d_{ij} x^i y^j, (i+j) \leq m$$

301

X/Y

4X

+

+

r0y,r1y,gy,by

r0x,r1x,gx,bx

302

**Fig. 3**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- WO 2009025976 A

**In der Beschreibung aufgeführte Nicht-Patentliteratur**

- A review of image-warping methods. **GLASBEY C. et al.** Journal of apllied statistics. Carfax publishing Co, 01. April 1998, vol. 25, 155-171